# EUROPEAN PATENT APPLICATION

(11) **EP 3 955 268 A1**
(43) Date of publication of application: **16.02.2022**
(21) Application number: 21189825.9
(22) Date of filing: 05.08.2021
(51) Int. Cl.: H01F 1/057

(54) **NDFEB ALLOY POWDER FOR FORMING HIGH-COERCIVITY SINTERED NDFEB MAGNETS AND USE THEREOF**

(30) Priority: 08.08.2020 CN 202010792279
(71) Applicant: Yantai Shougang Magnetic Materials Inc., 265500 Yantai (CN)
(72) Inventor: Yang, Kunkun, Yantai-City, 265500 (CN); Peng, Zhongjie, Yantai-City, 265500 (CN); Ding, Kaihong, Yantai-City, 265500 (CN)
(74) Representative: Gulde & Partner

(57) **Abstract**

The invention provides a novel NdFeB alloy powder for forming high-coercivity sintered NdFeB magnets. The NdFeB alloy powder includes NdFeB alloy core particles with a mixed metal coating. The mixed metal coating is formed by simultaneously vapor deposition of
a) at least one high-melting metal M selected from the group consisting of Mo, W, Zr, Ti, and Nb; and
b) at least one metal R, where R is selected from the group consisting of Pr, Nd, La, and Ce; or
a metal alloy RX, where X is one selected from the group consisting of Cu, Al, and Ga and R is at least one selected from the group consisting of Pr, Nd, La, and Ce.

## Description

### Background of the invention

### 1. Field of the Invention

The invention relates to the technical field of high-coercivity sintered NdFeB magnets, in particular to a NdFeB alloy powder for forming high-coercivity sintered NdFeB magnets and the use thereof.

### 2. Description of the Prior Art

NdFeB magnets are an important technical filed of rare earth applications and the demand for high-performance NdFeB magnet materials is still increasing. The coercivity of sintered NdFeB is a very important magnetic parameter and a sensitive parameter of the structure. It is mainly affected by the HA of the main phase grain of the magnet and the grain boundary between the main phase grains. The larger the HA of the main phase grains, the greater the final coercive force of the magnet, the wider and more continuous the grain boundary between the main phase grains, the higher is the coercive force of the magnet.

The so-called dual alloy method of the light rare earth auxiliary alloy uses the low melting point of a light rare earth alloy. During heat treatment at a temperature higher than its melting point, liquid diffusion occurs, and the main phase grains are distributed in a thin grid around the main phase grains. The process ensures a good isolation and demagnetization coupling effect thereby improving the coercive force of the magnet. However, the traditional dual alloy technology cannot achieve complete separation of the main phase grains by the grain boundary phase, which in turn leads to a small increase in the coercivity of the NdFeB magnet.

In the magnetic powder surface diffusion method, light rare earth film is coated on the surface of NdFeB magnetic powder through coating and other methods, and then it is pressed and sintered to improve the coercivity of the NdFeB magnet. For example, patent document CN104124052A discloses the use of magnetron sputtering method to deposit light rare earth alloy on NdFeB magnet powder, followed by pressing and sintering. Using the liquid diffusion of light rare earth alloy on the surface of the magnetic powder during the sintering process expands the grain boundary phase and the connecting grain boundary phase and forms a networked grain boundary distribution leading to high-performance NdFeB sintered magnets.

However, in the above-mentioned patents, since the coating on the surface of the magnetic powder is all low-melting metal, during the sintering and aging process, the coating on the surface of the magnetic powder participates in the flow of liquid diffusion resulting in different main phase grains due to the flow of the grain boundary phase. It is very easy to have direct contact, so it is impossible to guarantee the complete isolation between the crystal grains of different main phases in the prepared sintered NdFeB magnet. Therefore, the coercive force of the sintered NdFeB magnet prepared by the above-mentioned magnetic powder surface diffusion method is relatively high. The coercivity of the prepared sintered NdFeB magnet without the magnetic powder surface diffusion method has a small increase in coercivity.

### Summary of the invention

The purpose of the present invention is to solve the problem that it is difficult to form a uniform network grain boundary phase in the traditional magnetic powder surface diffusion method, which results in a low increase in the coercivity of the NdFeB magnet.

According to one aspect of the present disclosure there is provided a novel NdFeB alloy powder for forming high-coercivity sintered NdFeB magnets as defined in claim 1. The NdFeB alloy powder includes NdFeB alloy core particles with a mixed metal coating. The mixed metal coating is formed by simultaneously vapor deposition of
a) at least one high-melting metal M selected from the group consisting of Mo, W, Zr, Ti, and Nb; and
b) at least one metal R, where R is selected from the group consisting of Pr, Nd, La, and Ce; or
a metal alloy RX, where X is one selected from the group consisting of Cu, Al, and Ga and R is at least one selected from the group consisting of Pr, Nd, La, and Ce.

Another aspect of the present disclosure relates to the use of the NdFeB alloy powder for preparing a sintered NdFeB magnet.

Yet another aspect of the present disclosure refers to a sintered NdFeB magnet, which is produced from the modified NdFeB alloy powder.

Further aspects of the present invention could be learned from the dependent claims or following description.

### Description of the Figures

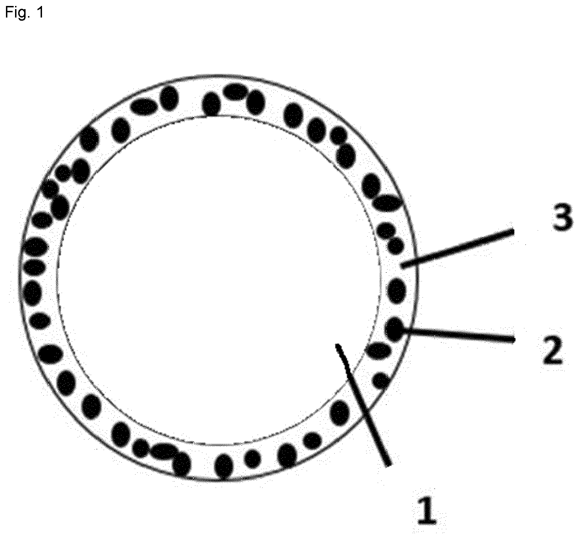

Figure 1 is a schematic illustration of a particle of the inventive NdFeB alloy powder bearing a mixed metal coating deposited on the surface.

### Detailed description of the invention

Reference will now be made in detail to embodiments. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

According to one aspect of the present disclosure there is provided a novel NdFeB alloy powder for forming high-coercivity sintered NdFeB magnets. The NdFeB alloy powder includes NdFeB alloy core particles with a mixed metal coating. The mixed metal coating is formed by simultaneously vapor deposition of
a) at least one high-melting metal M selected from the group consisting of Mo, W, Zr, Ti, and Nb; and
b) at least one metal R, where R is selected from the group consisting of Pr, Nd, La, and Ce; or
a metal alloy RX, where X is one selected from the group consisting of Cu, Al, and Ga and R is at least one selected from the group consisting of Pr, Nd, La, and Ce.

Compared with the prior art, the NdFeB alloy powder provides the following advantages:
During the sintering and aging process of the sintered NdFeB magnet, the high-melting metal M in the mixed metal coating on the surface of the NdFeB alloy powder supports the formation of a crystal boundary channel between different main phase grains. The metal R, respectively metal alloy RX has a lower melting point and spreads in the crystal boundary channel to form a uniform mesh crystal boundary phase thereby improving the coercivity of the sintered NdFeB magnet significantly.

A Nd-Fe-B magnet (also known as NIB or Neo magnet) is the most widely used type of rareearth magnet. It is a permanent magnet made from an alloy of neodymium, iron, and boron to form the Nd2Fe14B tetragonal crystalline structure as a main phase. Besides, the microstructure of Nd-Fe-B magnets includes usually a Nd-rich phase. The alloy may include further elements in addition to or partly substituting neodymium and iron, which is however not important for the present invention far as the microstructure includes the main phase and the Nd-rich phase. In other words, a Nd-Fe-B magnet at presently understood covers all such alloy compositions. Because of different manufacturing processes, Nd-Fe-B magnets are divided into two subcategories, namely sintered Nd-Fe-B magnets and bonded Nd-Fe-B magnets. Conventional manufacturing processes for both subcategories usually include the sub-step of preparing Nd-Fe-B powders from Nd-Fe-B alloy flakes obtained by a strip casting process. The presently presented process refers to sintered Nd-Fe-B magnets.

The composition of the Nd-Fe-B powder may refer to the commercially available generalpurpose sintered Nd-Fe-B grades. For example, its basic composition can be set to REₐT(1-abc)B_{b}M_{c}, where RE is a rare earth element selected from at least one of Pr, Nd, Dy, Tb, Ho, and Gd, T is at least one of Fe or Co, B is element B, M is at least one of Al, Cu, Ga, Ti, Zr, Nb, Mo, and V, and a, b, and c may be 27wt.%≤a≤wt.33%, 0.85wt.%≤b≤1.3wt.%, and c≤5wt.%.

Commercially available or freshly produced alloy powders could be used for the inventive process of preparing the Nd-Fe-B powders, respectively sintered Nd-Fe-B magnets. Specifically, Nd-Fe-B alloy flakes may be produced by a strip casting process, then subjected to a hydrogen embrittlement process and jet milling for preparing the desired Nd-Fe-B magnet powders, which are modified by depositing a mixed metal coating. The strip casting process, the hydrogen embrittlement process, and the jet milling process are currently well-known technologies. In other words, preparation and composition of the NdFeB alloy core particles is well-known in the art.

An average particle size D50 of the NdFeB alloy core particles is in the range of 2 to 6 µm, specifically in the range of 3 to 5 µm. The average particle size of the particles may be for example measured by a laser diffraction device using appropriate particle size standards. Specifically, the laser diffraction device is used to determine the particle size distribution of the particles, and this particle distribution is used to calculate the arithmetic average of particle size.

According to the present disclosure, the NdFeB alloy powders consists of NdFeB core particles on which a mixed metal coating is deposited by vapor deposition, in particular magnetron sputtering.

The mixed metal coating includes as a first component a high-melting metal M and as a second component a metal R or metal alloy RX.

The high-melting metal M is at least one selected from the group consisting of Mo, W, Zr, Ti, and Nb.

According to a first alternative, the second component of the mixed metal coating is at least one metal R selected from the group consisting of Pr, Nd, La, and Ce. Preferably, the metal R is one of Pr or Nd. According to a second alternative, the second component of the mixed metal coating is a metal alloy RX, where X is one selected from the group consisting of Cu, Al, and Ga and R is at least one selected from the group consisting of Pr, Nd, La, and Ce.

Preferred metal alloys RX are NdCu, PrAI, and LaGa.

A thickness of the mixed metal coating may be in the range of 3 to 100 nm, in particular in the range of 20 to 50 nm.

A weight ratio of the metal R or metal alloy RX to the high-melting metal M in the mixed metal coating may be in the range of 5:1 to 50:1, in particular in the range of 10:1 to 30:1.

Figure 1 illustrates schematically an exemplary NdFeB alloy core particle 1 with a mixed metal coating as described above. The mixed metal coating is directly disposed on the NdFeB alloy core particle 1 and includes domains 2 consisting of the high-melting metal M embedded into ma matrix 3 of the metal R, respectively metal alloy RX. The concrete morphology of the coating depends on the miscibility of the metallic components. Homogeneous coatings are therefore also possible.

The modified NdFeB alloy powder could be used for preparing a sintered NdFeB magnet. For example, such a preparation process may include the following steps:
a. NdFeB alloy raw materials for forming the NdFeB alloy core particles are smelted and quickly solidified to prepare NdFeB alloy flakes. The NdFeB alloy flakes are placed in a hydrogen treatment furnace. Hydrogen absorption treatment and high temperature dehydrogenation treatment is carried out for crushing the flakes into smaller particles. The crushed flakes particles are milled to NdFeB alloy powder by jet milling.
b. A vapor deposition method is used to form a mixed metal coating on the NdFeB alloy powder of step a. A high-melting metal M and metal R or metal alloy RX are deposited simultaneously on the NdFeB powder to form the mixed metal coating, where the metal M is at least one of Mo/W/Zr/Ti/Nb, R is at least one of Pr/Nd/La/Ce, and X is one of Cu/AI/Ga.
c. The NdFeB alloy powder deposited with the mixed metal coating is formed by magnetic field orientation and cold isostatic pressing to a blank, which is vacuum sintered to obtain a high-coercivity sintered NdFeB magnet. The sintering temperature may be in the range of 1000°C to 1150°C, and the sintering time may be 2 to 10h. In particular, the sintering temperature may be 1050°C to 1100°C and the sintering time may be 4 to 6h.

### Exemplary Embodiments

For the following examples, the formation of the NdFeB alloy powders are made with the same raw materials using the same process of hydrogen decrepitation. Each example is only different in the average particle size D50 of the NdFeB alloy powder achieved by jet milling. The NdFeB alloy powders are divided into group A and group B. Among them, the NdFeB alloy powder of group A is not subjected to any treatment, and the NdFeB alloy powder of group B is treated by a vapor deposition method to form a mixed metal coating. The vapor deposition of all metals of the mixed metal coating is simultaneously performed, i.e. at least one high-melting metal selected from the group consisting of Mo, W, Zr, Ti, and Nb is deposited on the NdFeB powder together with the metal R, respectively metal alloy RX to form the mixed metal coating. Simultaneously means that the deposition sources for the two components are opened and closed at the same time. During the process of deposition coating, two layers of the components can be deposited on the NdFeB powder at the same time to form the mixed metal coating. The coating can therefore consist of individual islands of the different materials, which is particularly the case when the two components do not mix.

In the following embodiments, NdFeB alloy flakes are used based on raw materials of the same alloy ratio. The NdFeB alloy flakes are processed in the same way before the NdFeB alloy powder is made by jet milling. Specifically, the smelting preparation composition for preparing the NdFeB alloy flakes is Nd: 23.4%, Pr: 5.1%, Al: 0.45%, Co: 0.5%, Cu: 0.15%, Ga: 0.2%, B: 0.93%, Ho: 2.0%, Ti: 0.15% with the remaining composition being Fe. Hydrogen decrepitation of the NdFeB alloy flakes is performed in a furnace. 1% of the total alloy weight of an anti-oxidant and 0.2% of the lubricant are added to the crushed powder of the hydrogen decrepitation step, which is thoroughly mixed and placed in a jet mill for further crushing.

### Example 1

NdFeB alloy powder with an average particle size D50 of 2µm is produced by jet milling and evenly divided into batch A and batch B. The NdFeB alloy powder of batch A is not processed in any way. On the surface of the particles of the NdFeB alloy powder of batch B, high-melting metal W and metal Pr are simultaneously deposited by magnetron sputtering. The deposition process is controlled such that a weight ratio of deposited Pr to W is about 5:1 and a thickness of the mixed metal coating is about 3nm.

Afterwards, batch A and batch B of the NdFeB alloy powders are respectively oriented and formed in a 1.8T magnetic field, and then subjected to 180Mpa cold isostatic pressing to form blanks.

The blanks were vacuum sintered at 1000°C for 10h, and then subjected to a primary tempering at 850°C for 6h and secondary tempering at 500°C for 5h to produce sintered NdFeB magnets A and B.

After cutting the magnets prepared above, the magnetic properties (temperature 20°C±3°C) are tested, and the test results are recorded in Table 1.

**Table 1**

| Sample | Br (T) | Hcj (kA/m) | Hk/Hcj |
|---|---|---|---|
| Magnet A | 1.345 | 1425 | 0.98 |
| Magnet B | 1.341 | 1568 | 0.98 |

It can be seen from Table 1 that in Example 1, when the composition of the NdFeB alloy powder is the same, the coercivity of the sintered NdFeB magnet prepared by the method described in this application is increased by 143 kA/m, and the increase effect is obvious.

### Example 2

NdFeB alloy powder with an average particle size D50 of 3µm is produced by jet milling and evenly divided into batch A and batch B. The NdFeB alloy powder of batch A is not processed in any way. On the surface of the particles of the NdFeB alloy powder of batch B, high-melting metal Mo and metal alloy NdCu are simultaneously deposited by magnetron sputtering. The deposition process is controlled such that a weight ratio of deposited NdCu to Mo is about 20:1 and a thickness of the mixed metal coating is about 20nm.

Afterwards, batch A and batch B of the NdFeB alloy powders are respectively oriented and formed in a 1.8T magnetic field, and then subjected to 180Mpa cold isostatic pressing to form blanks.

The blanks were vacuum sintered at 1100°C for 4h, and then subjected to a primary tempering at 850°C for 6h and secondary tempering at 500°C for 5h to produce sintered NdFeB magnets A and B.

After cutting the magnets prepared above, the magnetic properties (temperature 20°C±3°C) are tested, and the test results are recorded in Table 2.

**Table 2**

| Sample | Br (T) | Hcj (kA/m) | Hk/Hcj |
|---|---|---|---|
| Magnet A | 1.344 | 1449 | 0.98 |
| Magnet B | 1.335 | 1695 | 0.98 |

It can be seen from Table 2 that in Example 2, when the composition of the NdFeB alloy powder is the same, the coercivity of the sintered NdFeB magnet prepared by the method described in this application is increased by 246 kA/m, and the increase effect is obvious.

### Example 3

NdFeB alloy powder with an average particle size D50 of 4µm is produced by jet milling and evenly divided into batch A and batch B. The NdFeB alloy powder of batch A is not processed in any way. On the surface of the particles of the NdFeB alloy powder of batch B, high-melting metal Zr and metal Nd are simultaneously deposited by magnetron sputtering. The deposition process is controlled such that a weight ratio of deposited Nd to Zr is about 30:1 and a thickness of the mixed metal coating is about 30nm.

Afterwards, batch A and batch B of the NdFeB alloy powders are respectively oriented and formed in a 1.8T magnetic field, and then subjected to 180Mpa cold isostatic pressing to form blanks.

The blanks were vacuum sintered at 1050°C for 8h, and then subjected to a primary tempering at 850°C for 6h and secondary tempering at 500°C for 5h to produce sintered NdFeB magnets A and B.

After cutting the magnets prepared above, the magnetic properties (temperature 20°C±3°C) are tested, and the test results are recorded in Table 3.

**Table 3**

| Sample | Br (T) | Hcj (kA/m) | Hk/Hcj |
|---|---|---|---|
| Magnet A | 1.346 | 1425 | 0.98 |
| Magnet B | 1.34 | 1743 | 0.98 |

It can be seen from Table 3 that in Example 3, when the composition of the NdFeB alloy powder is the same, the coercivity of the sintered NdFeB magnet prepared by the method described in this application is increased by 318 kA/m, and the increase effect is obvious.

### Example 4

NdFeB alloy powder with an average particle size D50 of 5µm is produced by jet milling and evenly divided into batch A and batch B. The NdFeB alloy powder of batch A is not processed in any way. On the surface of the particles of the NdFeB alloy powder of batch B, high-melting metal Nb and metal alloy PrAI are simultaneously deposited by magnetron sputtering. The deposition process is controlled such that a weight ratio of deposited PrAI to Nb is about 10:1 and a thickness of the mixed metal coating is about 50nm.

Afterwards, batch A and batch B of the NdFeB alloy powders are respectively oriented and formed in a 1.8T magnetic field, and then subjected to 180Mpa cold isostatic pressing to form blanks.

The blanks were vacuum sintered at 1150°C for 2h, and then subjected to a primary tempering at 850°C for 6h and secondary tempering at 500°C for 5h to produce sintered NdFeB magnets A and B.

After cutting the magnets prepared above, the magnetic properties (temperature 20°C±3°C) are tested, and the test results are recorded in Table 4.

**Table 4**

| Sample | Br (T) | Hcj (kA/m) | Hk/Hcj |
|---|---|---|---|
| Magnet A | 1.344 | 1425 | 0.98 |
| Magnet B | 1.334 | 1894 | 0.98 |

It can be seen from Table 4 that in Example 4, when the composition of the NdFeB alloy powder is the same, the coercivity of the sintered NdFeB magnet prepared by the method described in this application is increased by 469 kA/m, and the increase effect is obvious.

### Example 5

NdFeB alloy powder with an average particle size D50 of 6µm is produced by jet milling and evenly divided into batch A and batch B. The NdFeB alloy powder of batch A is not processed in any way. On the surface of the particles of the NdFeB alloy powder of batch B, high-melting metal Ti and metal alloy LaGa are simultaneously deposited by magnetron sputtering. The deposition process is controlled such that a weight ratio of deposited LaGa to Ti is about 50:1 and a thickness of the mixed metal coating is about 100nm.

Afterwards, batch A and batch B of the NdFeB alloy powders are respectively oriented and formed in a 1.8T magnetic field, and then subjected to 180Mpa cold isostatic pressing to form blanks.

The blanks were vacuum sintered at 1020°C for 8h, and then subjected to a primary tempering at 850°C for 6h and secondary tempering at 500°C for 5h to produce sintered NdFeB magnets A and B.

After cutting the magnets prepared above, the magnetic properties (temperature 20°C±3°C) are tested, and the test results are recorded in Table 5.

**Table 5**

| Sample | Br (T) | Hcj (kA/m) | Hk/Hcj |
|---|---|---|---|
| Magnet A | 1.346 | 1417 | 0.98 |
| Magnet B | 1.312 | 1688 | 0.98 |

It can be seen from Table 5 that in Example 5, when the composition of the NdFeB alloy powder is the same, the coercivity of the sintered NdFeB magnet prepared by the method described in this application is increased by 271 kA/m, and the increase effect is obvious.

The above description is only exemplary and explanatory. The above examples show that the sintered NdFeB magnets prepared from simultaneously plated NdFeB powders have an improved coercivity. Specifically, NdFeB core particles are coated with the mixed metal coating have higher coercivity.

Simultaneously vapor deposition of metal M and metal R or metal alloy RX on NdFeB powder forms a mixed metal plating, where M metal is at least one of Mo/W/Zr/Ti/Nb, R is at least one of Pr/Nd/La/Ce, X is one of Cu/AI/Ga. By performing vacuum sintering and aging treatment after oriented pression a high-coercivity sintered NdFeB magnet is finally obtained. The invention uses the high melting point of metal M in the mixed coating on the surface of the NdFeB powder as the supporting part during the sintering and aging process to support the different main phase crystal grains to form a grain boundary channel. Metal R and metal alloy RX have a lower meting point and flow and diffuse in the grain boundary channel to form a networked grain boundary phase, which makes the coercive force of the NdFeB magnet significantly improved.

## Claims

1. A NdFeB alloy powder for forming high-coercivity sintered NdFeB magnets, the NdFeB alloy powder including NdFeB alloy core particles (1) with a mixed metal coating, wherein the mixed metal coating is formed by simultaneously vapor deposition of
a) at least one high-melting metal M selected from the group consisting of Mo, W, Zr, Ti, and Nb; and
b) at least one metal R, where R is selected from the group consisting of Pr, Nd, La, and Ce; or
a metal alloy RX, where X is one selected from the group consisting of Cu, Al, and Ga and R is at least one selected from the group consisting of Pr, Nd, La, and Ce.

2. The NdFeB alloy powder of claim 1, wherein an average particle size D50 of the NdFeB alloy core particles (1) is in the range of 2 to 6 µm.

3. The NdFeB alloy powder of claim 1 or 2, wherein a thickness of the mixed metal coating is in the range of 3 to 100 nm.

4. The NdFeB alloy powder of one of the preceding claims, wherein a weight ratio of the metal R or metal alloy RX to the high-melting metal M in the mixed metal coating is in the range of 5:1 to 50:1.

5. The NdFeB alloy powder of one of the preceding claims, wherein the mixed metal coating is formed by magnetron sputtering.

6. Use of the NdFeB alloy powder of one of the preceding claims for preparing a sintered NdFeB magnet.

7. A sintered NdFeB magnet produced from the NdFeB alloy powder of one of claims 1 through 5.
